(19) **Europäisches Patentamt / European Patent Office / Office européen des brevets**

(11) **EP 1 887 749 B1**

(12) **FASCICULE DE BREVET EUROPEEN**

(45) Date de publication et mention
de la délivrance du brevet:
**07.09.2016   Bulletin 2016/36**

(51) Int Cl.:
*H03F 3/24* (2006.01)          *H03F 1/32* (2006.01)
*H04L 27/26* (2006.01)

(21) Numéro de dépôt: **07113626.1**

(22) Date de dépôt: **01.08.2007**

(54) **Procédé de compensation numérique de non linéarités dans un système de communication et dispositif récepteur**

Verfahren zur Kompensation von Nichtlinearitäten in einem Kommunikationssystem und Empfängervorrichtung

Method of digital compensation of nonlinearities in a communication system and receiver device

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité:  **04.08.2006  FR 0607147**

(43) Date de publication de la demande:
**13.02.2008   Bulletin 2008/07**

(73) Titulaire: **Commissariat à l'Énergie Atomique et aux Énergies Alternatives
75015 Paris (FR)**

(72) Inventeurs:
• **Dehos, Cédric**
  **29100 Douarnenez (FR)**
• **Schenk, Tim**
  **5611HL Eindhoven (NL)**
• **Morche, Dominique**
  **38240 Meylan (FR)**

(74) Mandataire: **Ahner, Philippe et al
BREVALEX
95, rue d'Amsterdam
75378 Paris Cedex 8 (FR)**

(56) Documents cités:
**WO-A-96/13109     WO-A-2006/104408
GB-A- 2 407 950**

• IBNKAHLA[1] M: "Applications of neural networks to digital communications - a survey" SIGNAL PROCESSING, ELSEVIER SCIENCE PUBLISHERS B.V. AMSTERDAM, NL, vol. 80, no. 7, 1 juillet 2000 (2000-07-01), pages 1185-1215, XP004200936 ISSN: 0165-1684
• MOHAMED IBNKAHLA ET AL: "Neural Network Modeling and Identification of Nonlinear Channels with Memory: Algorithms, Applications, and Analytic Models" IEEE TRANSACTIONS ON SIGNAL PROCESSING, IEEE SERVICE CENTER, NEW YORK, NY, US, vol. 46, no. 5, 1 mai 1998 (1998-05-01), XP011058141 ISSN: 1053-587X
• GHARAIBEH K M ET AL: "Estimation of in-band distortion in digital communication system" MICROWAVE SYMPOSIUM DIGEST, 2005 IEEE MTT-S INTERNATIONAL LONG BEACH, CA, USA 12-17 JUNE 2005, PISCATAWAY, NJ, USA,IEEE, 12 juin 2005 (2005-06-12), pages 1963-1966, XP010844946 ISBN: 978-0-7803-8846-8

## Description

### DOMAINE TECHNIQUE ET ART ANTÉRIEUR

L'invention concerne un procédé de compensation numérique de non linéarités dans un système de communication, ainsi qu'un dispositif récepteur réalisant une telle compensation. L'invention concerne plus particulièrement la compensation des non linéarités d'un signal, amplifié à l'émission et/ou à la réception, et déformé par les non linéarités des amplificateurs ou composants actifs présents à l'émission et/ou à la réception dans le système de communication.

Des éléments non linéaires nécessaires à la transmission d'information, tels que des amplificateurs de puissance ou des amplificateurs faible bruit, sont présents dans les systèmes de communication. Sous l'effet des non linéarités de ces éléments, un signal de puissance variable transmis dans un de ces systèmes de communication se retrouve déformé, perturbant la reconstitution de l'information portée par ce signal à la réception.

Pour les systèmes utilisant des modulations à grande dynamique, tels que les systèmes UMTS (Universal Mobile Télécommunication System en anglais, ou système universel de télécommunication avec les mobiles), EDGE (Enhanced Data Rates for GSM Evolution en anglais, ou Débits augmentés pour l'évolution du GSM) ou multi porteuses de type OFDM (Orthogonal Frequency Division Multiplexing en anglais, ou Multiplexage à Répartition en Fréquence Orthogonale), par exemple selon les normes 802.11a, 802.11n, 802.16e, etc., il est nécessaire au bon fonctionnement du système que les amplificateurs utilisés à l'émission soient linéaires, au détriment de l'efficacité de ces amplificateurs et donc de la consommation énergétique du système.

Afin de pallier à ce défaut de linéarité, il existe des solutions dites « circuits », dont le but est d'aboutir à une amplification linéaire en corrigeant l'amplification réalisée. Il s'agit par exemple des méthodes de linéarisation d'amplificateurs telles que le contrôle dynamique de la polarisation de l'amplificateur (« dynamic biasing »), la boucle cartésienne (« cartesian loop »), la compensation analogique de l'erreur d'amplification (« feedforward »), ou encore l'utilisation de deux amplificateurs en parallèle (« LINC »).

Il existe également des solutions dites « numériques » dont le but est de déformer le signal reçu de façon inverse par rapport aux non linéarités subies par le signal durant la transmission, par des procédés de traitement du signal.

De nombreux schémas de pré-distorsion numérique ont été proposés, comme par exemple dans le document US 6 304 140, réalisant une table de pré-distorsion (« look up table »), ou du document WO 2006/019612 mettant en oeuvre une pré-distorsion avec prise en compte des effets de mémoire de l'amplificateur.

### EXPOSÉ DE L'INVENTION

Un but de la présente invention est de proposer un procédé permettant de compenser les non linéarités présentes dans tout ou une partie du système de communication de façon numérique. Pour cela, la présente invention propose un procédé de compensation numérique de non linéarités dans un système de communication comprenant un émetteur, un canal de transmission et un récepteur, pouvant comporter :

- au moins une étape d'estimation des non linéarités présentes à l'émission et/ou à la réception à partir d'au moins une séquence d'apprentissage, ou pilote, reçue au niveau du récepteur et déformée par lesdites non linéarités,
- au moins une étape de compensation des non linéarités déformant un signal reçu au niveau du récepteur à partir de l'estimation précédente des non linéarités.

La présente invention propose également un procédé de compensation numérique de non linéarités dans un système de communication comprenant un émetteur, un canal de transmission et un récepteur, comportant :

- au moins une étape d'estimation des non linéarités induites par l'émetteur et/ou le récepteur à partir d'au moins une séquence d'apprentissage, ou pilote, reçue au niveau du récepteur et déformée par lesdites non linéarités,
- au moins une étape de compensation desdites non linéarités déformant un signal reçu au niveau du récepteur à partir de l'estimation précédente des non linéarités.

Ainsi, il est possible de compenser les non linéarités présentes au niveau de l'émetteur, c'est-à-dire générées ou induites par l'émetteur, par exemple engendrées par un amplificateur de puissance présent dans l'émetteur, et/ou du récepteur, engendrées ou induites par le récepteur, par exemple par un amplificateur faible bruit (« Low Noise Amplifier » en anglais, ou LNA), par un mélangeur de fréquence (« mixer » en anglais) ou un amplificateur à gain variable (« Variable Gain Amplifier » en anglais, ou VGA) d'un système de communication.

Contrairement à l'art antérieur existant, les non linéarités sont compensées à la réception et non à l'émission, c'est-à-dire après que le signal ait été émis et ait traversé le canal de transmission. Il est donc possible d'utiliser au niveau de l'émetteur un amplificateur non linéaire car la correction des non linéarités du signal s'effectue au niveau de la réception du système de communication.

Selon l'invention, la complexité des algorithmes de compensation des non linéarités est reportée à la réception, ce qui est particulièrement avantageux, notamment dans le cas des réseaux cellulaires. Par exemple, dans le cas d'une liaison montante entre un terminal mobile et une station de base, il est préférable de reporter les contraintes sur la station de base, qui possède une plus grande capacité de traitement du signal par rapport au terminal mobile. Comme l'amplification de puissance représente une grande partie de la puissance consommée par le terminal mobile, le gain en efficacité obtenu à ce niveau par l'utilisation de composants non linéaires, tel l'amplificateur, permet d'augmenter de façon significative le temps d'utilisation du mobile ou reporter l'énergie économisée sur d'autres applications embarquées.

L'invention permet donc de s'affranchir des non linéarités de réponse de l'émetteur et/ou du récepteur qui sont une fonction non linéaire de la puissance (amplitude) du signal en entrée de l'émetteur et/ou du récepteur, contrairement aux non linéarités de canal, correspondant à la réponse fréquentielle du canal de propagation, qui ne sont pas liées à l'amplitude du signal émis.

L'invention peut aussi être mise en oeuvre dans une phase de calibration du récepteur. Les séquences connues (séquences apprentissage ou pilotes) ne proviennent plus alors de l'émetteur mais du récepteur. Dans ce cas, seules les non linéarités introduites par le récepteur sont compensées.

L'estimation des non linéarités peut être réalisée par les étapes de :

- calcul d'une basé orthonormée de polynômes de projection $\{p_0, p_1, \cdots, p_n\}$,

- calcul de l'approximation des non linéarités $\|\hat{g}(\|x\|)\|$ pour une caractéristique AM/AM et/ou une caractéristique AM/PM d'un élément de gain $g$ sur lequel est ramené l'ensemble des non linéarités du système de communication, respectivement en fonction de l'équation :

$$\left\|g(\|\hat{x}\|)\right\| = \sum_{k=0}^{n} cA_k \, p_k (\|x\|) \, ,$$

et/ou de l'équation :

$$angle\left(\hat{g}(\|x\|)\right) = \sum_{k=0}^{n} c\varphi_k \, p_k (\|x\|) \, ,$$

avec $\{cA_0, cA_1, \cdots, cA_n\}$ coefficients de la caractéristique AM/AM, $\{c\varphi_0, c\varphi_1, \cdots, c\varphi_n\}$ coefficients de la caractéristique AM/PM, $\|g(\|x\|)\|$ module de l'approximation des non linéarités et $angle(g(\|x\|))$ phase de l'approximation des non linéarités,

- calcul de points d'interpolation d'abscisse $a_i$ et d'ordonnée $b_i$ de la caractéristique des non linéarités $\hat{g}$ pour la caractéristique AM/AM et/ou de points d'interpolation d'abscisse $c_i$ et d'ordonnée $d_i$ de la caractéristique des non linéarités $\hat{g}$ pour la caractéristique AM/PM.

Selon l'invention, l'ensemble des non linéarités présentes dans le système de communication peut être ramené sur un seul élément de gain $g$, par exemple un amplificateur se trouvant au niveau de l'émetteur du système de communication. La caractéristique AM/AM de cet élément représente donc la courbe de l'amplitude du signal de sortie de cet élément en fonction de l'amplitude du signal en entrée de cet élément. La caractéristique AM/PM est alors la courbe de la phase du signal de sortie en fonction de l'amplitude du signal d'entrée de l'élément de gain $g$.

La compensation des non linéarités peut être réalisée par :

- une étape de compensation de la caractéristique AM/AM à partir d'un polynôme d'interpolation obtenu à partir de points d'interpolation inverse d'abscisse $b_i$ et d'ordonnée $a_i$ calculés préalablement, et/ou
- une étape de compensation de la caractéristique AM/PM par soustraction d'une distorsion de phase évaluée à la phase du signal reçue.

La compensation de la caractéristique AM/AM peut être obtenue par le calcul du signal :

$$s_3'(t) = \sum_{j=1}^{m} a_j \prod_{i \neq j} \frac{\|s_2(t)\| - b_i}{b_j - b_i} \exp(j.angle(s_2(t))) \, ,$$ avec $s_2(t)$ le signal recu, $\|s_2(t)\|$ le module du signal reçu,

$angle(s_2(t))$ la phase du signal reçu, $m$ le nombre de points d'interpolation, $(a_i, b_i)$ les coordonnées des points d'interpolation, le polynôme d'interpolation pouvant être un polynôme de Lagrange, et/ou la compensation de la caractéristique AM/PM pouvant être obtenue par le calcul du signal : $s_3(t) = s_3'(t).\exp(-j*angle(\hat{g}(\|s_3'\|)))$, $s_3(t)$ étant le signal reçu compensé des non linéarités et g l'approximation des non linéarités.

La compensation des non linéarités peut être réalisée par une compensation conjointe des caractéristiques AM/AM et AM/PM à partir d'un polynôme d'interpolation complexe par le calcul du signal :

$$s_3(t) = \sum_{j=1}^{m} a_j \prod_{i \neq j} \frac{s_2(t) - b_i}{b_j - b_i} \text{ , avec } s_2(t) \text{ le signal reçu, } s_3(t) \text{ le signal reçu compensé des non linéarités, } a_i \text{ et } b_i$$

étant respectivement les abscisses et les ordonnées de m points d'interpolation calculés préalablement.

Le procédé de compensation numérique de non linéarités selon l'invention peut comporter avant l'étape d'estimation des non linéarités, une étape d'estimation de la caractéristique du canal de transmission à partir d'au moins une autre séquence d'apprentissage transmise à travers le canal de transmission. Cette estimation permet de prendre en compte et de corriger la réponse impulsionnelle du canal de transmission.

La caractéristique estimée du canal peut être prise en compte pour l'estimation des non linéarités.

Le procédé de compensation numérique de non linéarités selon l'invention peut comporter après l'étape de compensation des non linéarités, une étape d'égalisation compensant le bruit du canal présent dans le signal reçu à partir de l'estimation de la caractéristique du canal de transmission.

Le procédé de compensation numérique de non linéarités selon l'invention peut comporter après l'étape de compensation des non linéarités, une étape de démodulation et/ou de décodage.

Les signaux et/ou séquences d'apprentissage reçus peuvent subir une transformation de Fourier rapide.

La séquence d'apprentissage reçue au niveau du récepteur pour l'estimation des non linéarités peut être émise depuis l'émetteur ou le récepteur.

La présente invention concerne également un dispositif récepteur destiné à recevoir des signaux émis par un émetteur à travers un canal de transmission, comportant des moyens de compensation numérique de non linéarités pouvant comprendre :

- des moyens d'estimation des non linéarités présentes à l'émission et/ou à la réception à partir d'au moins une séquence d'apprentissage reçue et déformée par lesdites non linéarités,

- des moyens de compensation des non linéarités déformant un signal reçu à partir de l'estimation précédente des non linéarités.

La présente invention concerne aussi un dispositif récepteur destiné à recevoir des signaux émis par un émetteur à travers un canal de transmission, comportant des moyens de compensation numérique de non linéarités comprenant :

- des moyens d'estimation des non linéarités induites par l'émetteur et/ou le récepteur à partir d'au moins une séquence d'apprentissage reçue et déformée par lesdites non linéarités,

- des moyens de compensation desdites non linéarités déformant un signal reçu à partir de l'estimation précédente des non linéarités.

Les moyens d'estimation des non linéarités peuvent comporter :

- des moyens de calcul d'une base orthonormée de polynômes de projection $\{p_0, p_1, \cdots, p_n\}$,

- des moyens de calcul de l'approximation des non linéarités $g(\|\hat{x}\|)$ pour une caractéristique AM/AM et/ou une caractéristique AM/PM d'un élément de gain g sur lequel est ramené l'ensemble des non linéarités du système de communication, respectivement en fonction de l'équation :

$$\|g(\|\hat{x}\|)\| = \sum_{k=0}^{n} cA_k \, p_k (\|x\|) \text{ ,}$$

et/ou de l'équation :

$$angle(\hat{g}(\|x\|)) = \sum_{k=0}^{n} c\varphi_k \, p_k (\|x\|) \text{ ,}$$

avec $\{cA_0, cA_1. \cdots, cA_n\}$ coefficients de la caractéristique AM/AM, $\{c\varphi_0, c\varphi_1, \cdots, c\varphi_n\}$ coefficients de la caractéristique AM/PM, $\|g(\|x\|)\|$ module de l'approximation des non linéarités et $angle(g(\|x\|))$ phase de l'approximation des non linéarités,

- des moyens de calcul de points d'interpolation d'abscisse $a_i$ et d'ordonnée $b_i$ de la caractéristique des non linéarités $g$ pour la caractéristique AM/AM et/ou de points d'interpolation d'abscisse $c_i$ et d'ordonnée $d_i$ de la caractéristique des non linéarités $\hat{g}$ pour la caractéristique AM/PM.

Les moyens de calcul d'une base orthonormée peuvent réaliser une orthonormalisation de Gram-Schmidt d'une base $\{1, x, x^2, x^3, \cdots, x^n\}$.

Les moyens de calcul des coefficients $\{cA_0, cA_1, \cdots, cA_n\}$ de la caractéristique AM/AM et/ou des coefficients $\{c\varphi_0, c\varphi_1, \cdots, c\varphi_n\}$ de la caractéristique AM/PM peuvent réaliser une projection de la séquence d'apprentissage sur la base orthonormée.

Les moyens de calcul de points d'interpolation d'abscisse $a_i$ et d'ordonnée $b_i$ pour la caractéristique AM/AM peuvent résoudre l'équation : $b_i = \|\hat{g}(a_i)\| = \sum_{k=0}^{n} cA_k \, p_k(a_i)$ , et/ou les moyens de calcul des points d'interpolation d'abscisse $c_i$ et d'ordonnée $d_i$ pour la caractéristique AM/PM pouvant résoudre l'équation :

$$d_i = angle(\hat{g}(c_i)) = \sum_{k=0}^{n} c\varphi_k \, p_k(c_i) .$$

Les moyens de calcul d'une base orthonormée peuvent réaliser une orthonormalisation de Gram-Schmidt d'une base $\{1, x, x^* x^2, xx^*, \cdots\}$ 1 et les moyens de calcul de l'approximation des non linéarités résolvant l'équation :

$$\hat{g}(\|x\|) = \|\hat{g}(\|x\|)\| \exp\left( j.angle\left( \hat{g}(\|x\|) \right) \right) = \left( \sum_{k=0}^{n} cA_k \, p_k(\|x\|) \right) \exp\left( j^* \left( \sum_{k=0}^{n} c\varphi_k \, p_k(\|x\|) \right) \right)$$

Les moyens de compensation des non linéarités peuvent comporter :

- des moyens de compensation de la caractéristique AM/AM à partir d'un polynôme d'interpolation obtenu à partir de points d'interpolation d'abscisse $a_i$ et d'ordonnée $b_i$ calculés préalablement, et/ou
- des moyens de compensation de la caractéristique AM/PM par soustraction d'une distorsion de phase évaluée à la phase du signal reçue.

Les moyens de compensation de la caractéristique AM/AM peuvent réaliser le calcul du signal :

$$s_3'(t) = \sum_{j=1}^{m} a_j \prod_{i \neq j} \frac{\|s2(t)\| - b_i}{b_j - b_i} \exp(j.angle(s2(t))) ,$$ avec $s_2(t)$ le signal reçu, $\|s_2(t)\|$ le module du signal

reçu, $angle(s_2(t))$ la phase du signal reçu, m le nombre de points d'interpolation, $(a_i, b_i)$ les coordonnées des points d'interpolation et le polynôme d'interpolation étant un polynôme de Lagrange, et/ou les moyens de compensation de la caractéristique AM/PM pouvant réaliser le calcul du signal : $s_3(t) = s_3'(t).\exp(-j^*angle(\hat{g}(\|s_3'\|)))$, $s_3(t)$ étant le signal reçu compensé des non linéarités et g l'approximation des non linéarités.

Les moyens de compensation des non linéarités peuvent réaliser une compensation conjointe des caractéristiques AM/AM et AM/PM à partir d'un polynôme d'interpolation complexe par le calcul du signal :

$$s_3(t) = \sum_{j=1}^{m} a_j \prod_{i \neq j} \frac{s2(t) - b_i}{b_j - b_i} .$$

Le dispositif récepteur, objet de la présente invention, peut comporter des moyens d'estimation de caractéristique de canal de transmission à partir d'au moins une autre séquence d'apprentissage transmise à travers le canal de transmission.

La caractéristique estimée du canal peut être prise en compte par les moyens d'estimation des non linéarités.

Le dispositif récepteur, objet de la présente invention, peut comporter des moyens d'égalisation compensant le bruit du canal présent dans le signal reçu à partir de l'estimation de la caractéristique du canal de transmission.

Le dispositif récepteur selon l'invention peut également comporter des moyens de démodulation et/ou de décodage.

Le dispositif récepteur selon l'invention peut comporter des moyens de transformation de Fourier rapide (FFT) réalisant une FFT des signaux et/ou séquences d'apprentissage reçus.

Le dispositif récepteur peut être une station de base sans fil.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- la figure 1 représente un déroulement temporel du procédé de compensation numérique de non linéarités dans un système de communication, objet de la présente invention,
- la figure 2 représente des caractéristiques AM/AM et AM/PM réelles d'un amplificateur et l'approximation des caractéristiques AM/AM et AM/PM obtenues durant le procédé de compensation numérique des non linéarités, objet de la présente invention,

- la figure 3 représente un polynôme d'interpolation de Lagrange obtenu durant le procédé de compensation numérique des non linéarités, objet de la présente invention,
- les figures 4A et 4B représentent des résultats d'une simulation de compensation des caractéristiques AM/AM et AM/PM,
- la figure 5 représente le gain en terme de taux d'erreur binaire obtenu par le procédé, objet de la présente invention,
- la figure 6 représente un système de communication comportant un dispositif récepteur, également objet de la présente invention.

Des parties identiques, similaires ou équivalentes des différentes figures décrites ci-après portent les mêmes références numériques de façon à faciliter le passage d'une figure à l'autre.

## EXPOSÉ DÉTAILLÉ DE MODES DE RÉALISATION PARTICULIERS

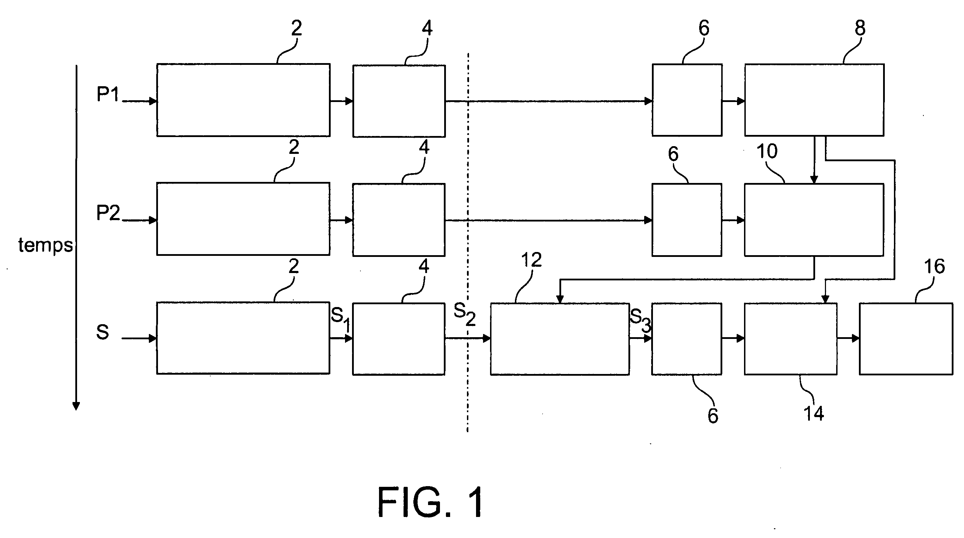

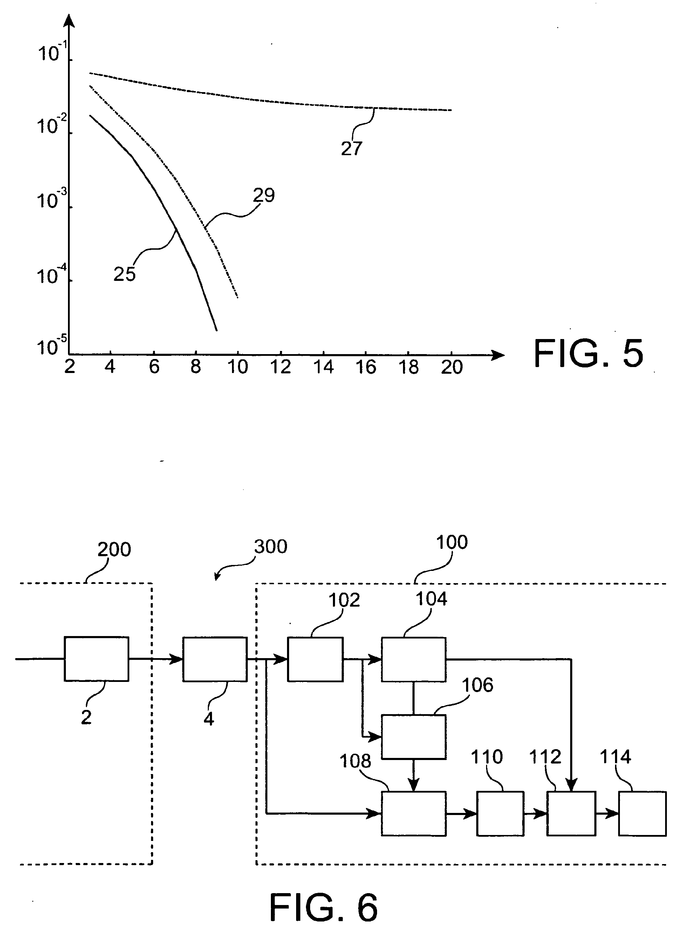

On se réfère tout d'abord à la figure 1 qui représente un déroulement temporel d'un procédé de compensation numérique de non linéarités dans un système de communication 300, objet de la présente invention, selon un mode de réalisation particulier, conjointement à la figure 6 représentant le système de communication 300 comportant un dispositif récepteur 100, également objet de la présent invention, telle une station de base. Dans ce mode de réalisation, le procédé est appliqué à un système de communication 300 sans fil à modulation de type OFDM entre un terminal mobile 200 et une station de base 100. Mais l'invention peut également s'appliquer à d'autres systèmes de type mono porteuse ou ultra large bande, entre un émetteur quelconque et un récepteur quelconque.

Dans l'exemple des figures 1 et 6, un amplificateur de puissance 2 se trouvant au niveau de du terminal mobile 200 est considéré comme l'unique source de non linéarités dans tout le système de communication 300. Mais l'invention permet de compenser d'autres sources de non linéarités dans le système de communication 300, au niveau de l'émetteur 200 et/ou du récepteur 100, comme celles dues par exemple à un amplificateur faible bruit, un amplificateur à gain variable, un mélangeur, etc.

Les signaux considérés sont ici complexes et échantillonnés dans le domaine temporel ou fréquentiel.

Soit s un signal destiné à être amplifié par l'amplificateur de puissance 2 et sortant de l'amplificateur 2 sous une forme s1 avant d'être émis dans un canal de transmission 4. Dans le domaine temporel, on a :

$$s_1(t) = g\big(\|s(t)\|\big).s(t) \qquad (1)$$

où g est le gain de l'amplificateur.

g est fonction de l'amplitude du signal d'entrée s. Ce gain g peut modifier l'amplitude et/ou la phase du signal d'entrée s de manière non linéaire, introduisant des non linéarités dans le système de communication 300 lorsque la caractéristique AM/AM, c'est-à-dire la courbe de l'amplitude du signal de sortie en fonction de l'amplitude du signal d'entrée, et/ou la caractéristique AM/PM, c'est-à-dire la courbe de la phase du signal de sortie en fonction de l'amplitude du signal d'entrée, de l'élément de gain g, ici l'amplificateur 2, n'est pas linéaire.

Dans le domaine fréquentiel, S1 est le résultat de la convolution entre le gain G de l'amplificateur 2 et le signal S entrant dans l'amplificateur :

$$S_1(f) = G(S(f)) * S(f) \qquad (2)$$

Le signal amplifié S1 est ensuite émis par une ou plusieurs antennes, et passe dans le canal de transmission 4. On obtient en sortie du canal de transmission 4 un signal S2 tel que :

$$S_2(f) = H(f).S_1(f) + \eta(f) \qquad (3)$$

où H représente la caractéristique de transmission du canal 4 dans le domaine fréquentiel et $\eta$ un bruit additif blanc gaussien.

Dans ce mode de réalisation, on utilise, préalablement à la transmission du signal d'information S, au moins une première séquence d'apprentissage, ou pilote, P1, pour réaliser une estimation de la caractéristique du canal 4. Pour cela, P1 suit le même trajet de transmission que les signaux d'informations à transmettre, c'est-à-dire subissant tout d'abord une étape d'amplification par l'amplificateur de puissance 2, puis une traversée du canal de transmission 4. A la réception, c'est-à-dire en sortie du canal de transmission 4, P1 subi, dans ce mode de réalisation, une transformation de Fourier rapide (FFT) (référence 6 sur la figure 1) afin de passer P1 dans le domaine fréquentiel. Sur la figure 6, cette FFT est réalisée par des moyens de transformation de Fourier rapide 102. Cette FFT est par exemple utilisée dans le cas d'un système OFDM, comme c'est le cas dans ce mode de réalisation.

Après cette FFT, on réalise alors une estimation 8 de la caractéristique du canal 4. Cette estimation est réalisée par des moyens 104 d'estimation de caractéristique de canal. L'amplitude de P1 est de préférence choisie sensiblement constante ou de faible dynamique, c'est-à-dire ayant un faible PAPR (« Peak to Average Power Ratio » en anglais, correspondant au rapport de la puissance de crête sur la puissance moyenne). Seule la phase de P1 change. Ainsi, les non linéarités présentes dans le système de communication 300 ne biaisent pas l'estimation du canal 4 car ainsi, elles n'ont pas ou peu d'influence sur P1. Cette estimation du canal 4 est réalisée en mesurant, fréquence par fréquence, la différence entre la séquence reçue en sortie du canal 4 et la séquence d'apprentissage P1 initiale. Par exemple, dans le cas d'un système OFDM, la caractéristique du canal 4 est obtenue directement à partir du rapport entre la séquence reçue et la séquence d'apprentissage P1 initiale, cette séquence étant par exemple une suite alternée de symboles de valeurs +1 et -1.

On réalise, après avoir obtenu l'estimation du canal 4, une estimation 10 des non linéarités présentes dans le système de communication 300. Dans l'exemple des figures 1 et 6, les non linéarités estimées sont celles de l'amplificateur de puissance 2. Cette estimation 10 des non linéarités consiste à déterminer des points d'interpolation de la caractéristique AM/AM et/ou de la caractéristique AM/PM de l'amplificateur 2.

Pour cela, au moins un pilote P2 est tout d'abord amplifié par l'amplificateur de puissance 2 puis envoyé à travers le canal de transmission 4. Etant donné que le système de communication est de type OFDM, le pilote P2 subi une FFT 6 par les moyens de FFT 102, comme précédemment pour P1 lors de l'estimation du canal 4. Cette estimation 10 est réalisée par des moyens d'estimation de non linéarités 106.

Pour réaliser l'estimation 10 des non linéarités, on calcul tout d'abord une base orthonormée de polynômes de projection $\{p_0, p_1, \cdots, p_n\}$. Cette base est obtenue à partir des moments de l'amplitude des séquences d'apprentissage ou pilotes émis, c'est-à-dire à partir des moments de l'amplitude de P2 initial avant qu'il ne soit envoyé à travers l'amplificateur de puissance 2 et le canal 4.

Après que P2 ait subi la FFT 6, on peut déterminer des coefficients $\{cA_0, cA_1, \cdots, cA_n\}$ de la caractéristique AM/AM et/ou des coefficients $\{c\varphi_0, c\varphi_1, \cdots, c\varphi_n\}$ de la caractéristique AM/PM par projection de P2 sur la base orthonormée $\{p_0, p_1, \cdots, p_n\}$. Ces coefficients permettent d'obtenir une approximation des non linéarités telle que :

$$\hat{g}(\|x\|) = (cA_0 p_0(\|x\|) + cA_1 p_1(\|x\|) + ..cA_n p_n(\|x\|)) \exp(j * (c\varphi_0 p_0(\|x\|) + c\varphi_1 p_1(\|x\|) + ..c\varphi_n p_n(\|x\|))) \qquad (4)$$

Cette projection permet d'obtenir une bonne estimation de l'ensemble de la caractéristique des non linéarités malgré la présence de bruit dans le canal 4.

Enfin, à partir de cette approximation, on calcule des points d'interpolation de coordonnées $b_i = g(a_i)$ de la caractéristique des non linéarités $\hat{g}$.

Les différentes amplitudes des symboles formant la séquence d'apprentissage P2 seront choisies pour couvrir le plus possible toute la dynamique de l'amplitude des signaux transmis ultérieurement par le système de communication 300, afin de prendre en compte l'ensemble des non linéarités subies par les signaux transmis à travers le système de communication 300.

L'estimation de la caractéristique AM/AM va maintenant être détaillée.

Préalablement au calcul de la base orthonormée de polynômes de projection $\{p_0, p_1, \cdots, p_n\}$, il convient de définir un produit scalaire adapté à l'espace vectoriel formé par cette base orthonormée.

Dans le domaine temporel, le produit scalaire associé à cette orthonormalisation est l'espérance du produit sur une certaine durée d'observation T, tel que :

$$\langle u, v \rangle = E\big[u(t)v(t)\big]_{t \in [0,T]} \qquad (5)$$

Pour un système échantillonné à $T_e = \dfrac{T}{N}$ :

$$\langle u, v \rangle = \sum_{k=0}^{N} u(k)v(k) \qquad (6)$$

Dans le domaine fréquentiel, le produit scalaire associé à cette orthonormalisation est l'espérance du produit de convolution sur une certaine bande de fréquence d'observation B, tel que :

$$\langle U, V \rangle = E\big[U(f) * V(f)\big]_{f \in [0,B]} \qquad (7)$$

Pour un système échantillonné à $F_e = F * N$ :

$$\langle U, V \rangle = \sum_{k=0}^{N} U(k)V(k) \qquad (8)$$

Ce produit scalaire choisi est bien une fonction bilinéaire, symétrique et définie positive.

Une base orthonormée de polynômes de projection $\{p_0, p_1, \cdots, p_n\}$ peut être obtenue par la méthode d'orthonormalisation de Gram-Schmidt d'une base $\{1, x, x^2, x^3, x^n\}$.

Voici par exemple les trois premiers polynômes obtenus pour la base orthonormée dans le domaine temporel :

$$p_0(x) = 1$$

$$p_1(x) = \frac{x - \langle p_0, p \rangle p_0(x)}{\big\| x - \langle p_0, p \rangle p_0(x) \big\|} = \frac{x - \chi_1}{\sqrt{\chi_2 - \chi_1}}$$

$$p_2(x) = \frac{x^2 - \langle p_0, p^2 \rangle p_0(x) - \langle p_1, p^2 \rangle p_1(x)}{\big\| x^2 - \langle p_0, p^2 \rangle p_0(x) - \langle p_1, p^2 \rangle p_1(x) \big\|} =$$

$$\frac{x^2 - (\chi_3 - \chi_2\chi_1)x + ((\chi_3 - \chi_2\chi_1)\chi_1 - \chi_2)}{\sqrt{\chi_4 + (\chi_3 - \chi_2\chi_1)^2 + ((\chi_3 - \chi_2\chi_1)\chi_1 - \chi_2)^2 - 2(\chi_3 - \chi_2\chi_1)\chi_2 + 2\chi_2((\chi_3 - \chi_2\chi_1)\chi_1 - \chi_2) - 2((\chi_3 - \chi_2\chi_1)\chi_1 - \chi_2)(\chi_3 - \chi_2\chi_1)\chi_1}}$$

Avec $\chi_1 = E[p]$, $\chi_2 = E[p^2]$, $\chi_3 = E[p^3]$, $\chi_4 = E[p^4]$ les moments de p, c'est-à-dire les moments de l'amplitude de P2 initial avant qu'il ne soit envoyé à travers l'amplificateur 2.

Pour une estimation dans le domaine fréquentiel, on construit de même une base orthonormée en prenant les formules (7) et (8) pour les calculs de produit scalaire.

Le nombre de polynômes formant cette base orthonormée est choisi en fonction de la précision souhaitée sur l'estimation des non linéarités, et de la complexité de l'algorithme qu'engendre un grand nombre de polynômes.

L'estimation 8 de canal réalisée précédemment est alors utilisée pour obtenir y(t), l'amplitude de P2 corrigée des effets du canal de transmission 4. Ainsi, on obtient une amplitude y(t) du pilote P2 affectée uniquement par les non linéarités de l'amplificateur 2.

On obtient alors une estimation de la caractéristique des non linéarités en effectuant la projection de y(t) sur la base orthonormée temporelle ou fréquentielle, préalablement calculée. Les coefficients $\{cA_0, cA_1, \cdots, cA_n\}$ de la caractéristique AM/AM sont obtenus par :

$$cA_k = \left\langle \|y\|, p_k \right\rangle \qquad (9)$$

Le calcul de l'approximation des non linéarités pour la caractéristique AM/AM peut donc être:

$$\left\| \hat{g}(\|s\|) \right\| = \sum_{k=0}^{n} \left\langle \|y\|, p_k \right\rangle p_k(\|s\|) = \sum_{k=0}^{n} cA_k \, p_k(\|s\|) \qquad (10)$$

Afin de pouvoir exploiter cette approximation, on calcule un certain nombre de points d'interpolation de la caractéristique des non linéarités g . On pourra par exemple choisir 5 points d'interpolation.

Soit $\{a_1, a_2,...,a_m\}$ les abscisses et $\{b_1, b_2,...,b_m\}$ les ordonnées des points d'interpolation de la caractéristique AM/AM.

Afin d'obtenir une bonne description des non linéarités de l'amplificateur de puissance 2, on peut choisir les $a_i$ de façon à avoir une majorité des points d'interpolation correspondant aux faibles amplitudes de la caractéristique AM/AM, par exemple en les répartissant de façon exponentielle.

Dans ce mode de réalisation, les ordonnées de ces points d'interpolation sont données par l'équation :

$$b_i = \left\| \hat{g}(a_i) \right\| = \sum_{k=0}^{n} cA_k \, p_k(a_i) = \sum_{k=0}^{n} \left\langle y, p_k \right\rangle p_k(a_i) \qquad (11)$$

Les $P_k(x)$ et $P_k(a_i)$ peuvent être calculés au préalable à partir du pilote utilisé P2, et des abscisses des points d'interpolation $a_i$, une multiplication-accumulation permettant ensuite d'obtenir les $b_i$.

Les points d'interpolation sont donc obtenus au prix d'une faible complexité. Cette projection permet d'exploiter la totalité des échantillons de y(t) disponibles, et ainsi d'obtenir une estimation des non linéarités robuste au bruits.

Afin d'obtenir une estimation de la caractéristique AM/PM, en choisissant la même base orthonormée temporelle, on projette la différence de phase φ(t) entre les séquences d'apprentissage ou pilotes, reçus et émis, sur cette base orthonormée.

De manière analogue à la caractéristique AM/AM, le calcul de l'approximation des non linéarités pour la caractéristique AM/PM peut donc être :

$$angle\left( \hat{g}(\|s\|) \right) = \sum_{k=0}^{n} \left\langle \varphi, p_k \right\rangle p_k(\|s\|) = \sum_{k=0}^{n} c\varphi_k \, p_k(\|s\|) \qquad (12)$$

Soit $\{c_1, c_2,..., c_n\}$ les abscisses et $\{d_1, d_2,..., d_n\}$ les ordonnées des points d'interpolation de la caractéristique AM/PM.

Dans ce mode de réalisation, les ordonnées de ces points d'interpolation sont données par l'équation :

$$d_i = angle(\hat{g}(c_i)) = \sum_{k=0}^{n} c\varphi_k \, p_k(c_i) = \sum_{k=0}^{n} \left\langle \varphi, p_k \right\rangle p_k(c_i) \qquad (13)$$

Afin d'obtenir une bonne description des non linéarités de l'amplificateur de puissance, on peut également choisir les abscisses $c_i$ de la caractéristique en phase de façon à avoir plus de points pour les faibles amplitudes, par exemple en les répartissant de façon exponentielle.

Pour obtenir à la fois les caractéristiques AM/AM et AM/PM, on peut soit projeter successivement amplitude et phase du pilote reçu selon les équations (10) et (12), soit utiliser une base orthonormale de l'espace des polynômes complexes pour la norme considérée.

Selon cette variante, l'orthonormalisation de Gram-Schmidt s'effectue alors à partir d'une base {1, *x*, *x*$^*$, $x^2$, $xx^*$,⋯}. Le pilote complexe reçu peut alors être projeté directement sur cette base.

L'approximation des non linéarités est donc dans ce cas :

$$\hat{g}(\|s\|) = \|\hat{g}(\|s\|)\| \exp\left( j.angle\left(\hat{g}(\|s\|)\right) \right) = \sum_{k=0}^{n} \langle y.\exp(j\varphi), p_k(s) \rangle p_k(\|s\|)$$

$$\hat{g}(\|s\|) = \left( \sum_{k=0}^{n} cA_k p_k(\|s\|) \right) \exp\left( j * \left( \sum_{k=0}^{n} c\varphi_k p_k(\|s\|) \right) \right) \tag{14}$$

Les points d'interpolation obtenus sont alors également complexes.

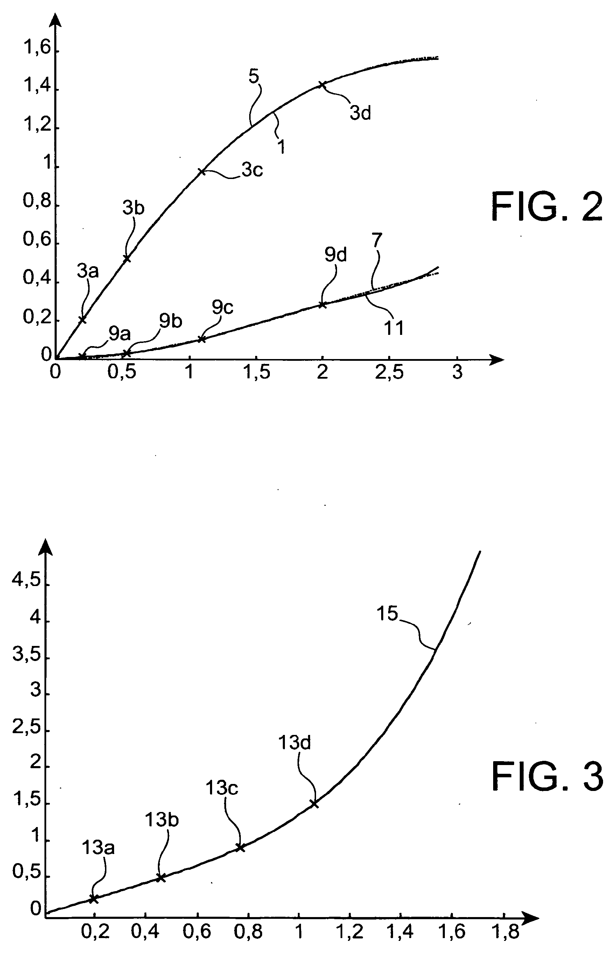

La figure 2 représente l'approximation des caractéristiques AM/AM et AM/PM obtenue par projection sur une base orthonormée de trois polynômes d'une séquence d'apprentissage de 64 échantillons temporels déformés à l'émission par un amplificateur de puissance à l'état solide (« Solid State Power Amplifier » en anglais, ou SSPA). La courbe 1 représente la caractéristique AM/AM réelle. A partir de 4 points d'interpolation 3a à 3d, on obtient l'approximation de la caractéristique AM/AM représentée par la courbe 5. On voit sur la figure 2 que l'approximation de la caractéristique AM/AM 5 est quasiment superposée à la caractéristique AM/AM réelle 1. Un résultat analogue est obtenu pour la caractéristique AM/PM, la courbe 7 représentant la caractéristique AM/PM réelle et la courbe 11 représentant l'approximation de la caractéristique AM/PM obtenue par les points d'interpolation 9a à 9d. L'approximation de la caractéristique AM/PM 11 obtenue est quasiment superposée à la caractéristique AM/PM réelle 7.

Les non linéarités étant estimées, il est maintenant possible de réaliser une compensation 12 des non linéarités subies par un signal s d'information transmis dans le système de communication 300.

La compensation des non linéarités peut s'effectuer tout de suite après la conversion analogique-numérique du signal dans le système de communication 300, après la transmission signal s dans le canal 4. Ce signal est noté $s_2(t)$ sur la figure 1. Sur la figure 6, le signal reçu est envoyé à des moyens de compensation de non linéarités 108.

Il est possible de réaliser une compensation de la caractéristique AM/AM, puis une compensation de la caractéristique AM/PM.

Dans ce cas, on calcule un polynôme d'interpolation, par exemple un polynôme de Lagrange, grâce aux points d'interpolation ($a_i,b_i$) pour inverser la caractéristique en amplitude de l'amplificateur 2. On obtient alors le signal :

$$s_3'(t) = \sum_{j=1}^{m} a_j \prod_{i \neq j} \frac{\|s_2(t)\| - b_i}{b_j - b_i} \exp(j.angle(s_2(t))) \tag{15}$$

Les abscisses et ordonnées des points d'interpolation ont été interverties. De cette manière on interpole directement la caractéristique inverse des non linéarités à partir de points d'interpolation inverse d'abscisse $b_i$ et d'ordonnée $a_i$. Les polynômes de Lagrange sont intéressants pour leur fiabilité à décrire une caractéristique bijective d'amplificateur et leur mise en oeuvre adaptée. D'autres polynômes d'interpolation, autres que ceux de Lagrange, peuvent également être choisis (splines, Newton, ...).

Grâce à ce procédé de compensation, il n'est pas nécessaire d'avoir un polynôme de Lagrange d'ordre élevé pour avoir une bonne compensation des non linéarités.

La figure 3 montre un polynôme d'interpolation de Lagrange 15, représentant la caractéristique AM/AM inverse, obtenu à partir de 4 points d'interpolation 13a à 13d dont les abscisses et les ordonnées ont été interverties.

La caractéristique AM/AM étant compensée, on évalue ensuite la distorsion de phase en fonction de l'amplitude par l'équation :

$$angle\left(\hat{g}(\|s_3'\|)\right) = \sum_{k=0}^{n} \langle \varphi, p_k \rangle p_k(\|s_3'\|) \tag{16}$$

Il suffit alors de retrancher cette phase à la phase du signal pour corriger la caractéristique AM/PM et obtenir en sortie de la compensation 12 des non linéarités :

$$s_3(t) = s_3'(t).\exp(-j * angle(\hat{g}(\|s_3\|)))\qquad(17)$$

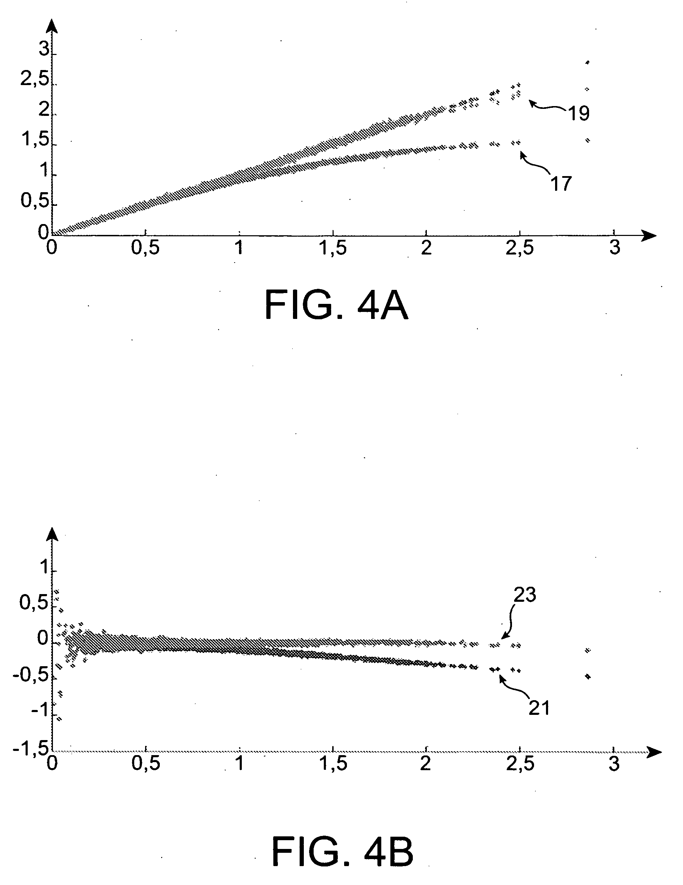

La figure 4A représente des résultats de simulation de compensation de la caractéristique AM/AM. L'ensemble de points 17 représente la caractéristique AM/AM obtenue en sortie sans procédé de compensation. L'ensemble de points 19 représente la caractéristique AM/AM obtenue avec le procédé de compensation selon l'invention, avec une séquence d'apprentissage de 64 symboles et en présence de bruit sur le canal de transmission. On voit que le procédé de compensation selon l'invention permet d'obtenir un signal compensé quasiment similaire à un signal linéaire. De même, la figure 4B représente des résultats de simulation de compensation de la caractéristique AM/PM. L'ensemble de points 21 représente la caractéristique AM/PM obtenue en sortie sans procédé de compensation. L'ensemble de points 23 représente la caractéristique AM/PM obtenue avec le procédé de compensation selon l'invention, avec une séquence d'apprentissage de 64 symboles et en présence de bruit sur le canal de transmission. Là encore, on voit que le procédé de compensation selon l'invention permet d'obtenir un signal compensé quasiment similaire à un signal linéaire.

Au lieu de compenser d'abord la caractéristique AM/AM, puis la caractéristique AM/PM, il est également possible de réaliser une compensation conjointe des caractéristiques AM/AM et AM/PM.

Dans ce cas, on utilise un polynôme de Lagrange complexe pour interpoler la caractéristique en amplitude et en phase de l'amplificateur :

$$s_3(t) = \sum_{j=1}^{m} a_j \prod_{i \neq j} \frac{s_2(t) - b_i}{b_j - b_i}\qquad(18)$$

où les couples $(a_i, b_i)$ sont obtenus après projection sur une base de polynômes complexes.

Le gain en terme de taux d'erreur binaire est représenté sur la figure 5. Sur cette figure, les courbes représentent le taux d'erreur binaire (« Bit Error Rate » en anglais, ou BER) en fonction du rapport signal à bruit (« Signal Noise Ratio » en anglais, ou SNR) pour un système OFDM comportant un amplificateur de type tube à onde progressive (ou TWT). Les courbes 25, 27 et 29 représentent respectivement le cas d'un signal idéal, un signal non compensé, et un signal compensé par le procédé selon l'invention.

Le signal dont les non linéarités ont été compensées peut ensuite être passé dans le domaine fréquentiel par une FFT 6 (figure 1) mise en oeuvre par des moyens de FFT 110 sur la figure 6, par exemple dans le cas d'un système de communication de type OFDM. Ce signal peut ensuite passer par une phase d'égalisation 14 pour compenser le bruit du canal 4. Cette phase d'égalisation peut être mise en oeuvre par des moyens d'égalisation 112. Cette égalisation 14 peut être obtenue en soustrayant l'estimation de canal 8 réalisée précédemment par les moyens 104 d'estimation de caractéristique de canal du signal reçu. Enfin, après la phase d'égalisation, le signal peut passer par une phase de décision 16 réalisant par exemple la démodulation et le décodage du signal, mise en oeuvre par des moyens 114 sur la figure 6.

L'invention est compatible avec un procédé de limitation ou d'écrêtage de la puissance à émettre (« clipping » en anglais) en amont de l'amplificateur de puissance 2, ainsi qu'un procédé de compensation des distorsions dues à ces écrêtages au récepteur. Pour cela, l'amplitude maximale de la séquence d'apprentissage ou du pilote est définie comme étant inférieure au niveau d'écrêtage.

Le procédé selon l'invention peut par exemple être mis en oeuvre dans des systèmes de communication de type OFDM, WCDMA, EDGE, ou plus généralement dans tous les systèmes de communication radio, filaire, optique, etc....

## Revendications

1. Procédé de compensation numérique de non linéarités dans un système de communication (300) comprenant un émetteur (200), un canal de transmission (4) et un récepteur (100), comportant :

   - au moins une étape (10) d'estimation des non linéarités induites par l'émetteur et/ou le récepteur, à partir d'au moins une séquence d'apprentissage reçue au niveau du récepteur (200) et déformée par lesdites non linéarités,
   - au moins une étape (12) de compensation desdites non linéarités déformant un signal reçu au niveau du récepteur à partir de l'estimation précédente des non linéarités.

2. Procédé selon la revendication 1, l'estimation (10) des non linéarités étant réalisée par les étapes de :

- calcul d'une base orthonormée de polynômes de projection $\{p_0, p_1, \cdots, p_n\}$,

- calcul de l'approximation des non linéarités $\hat{g}(\|x\|)$ pour une caractéristique AM/AM et/ou une caractéristique AM/PM d'un élément de gain g (2) sur lequel est ramené l'ensemble des non linéarités du système de communication (300), respectivement en fonction de l'équation :

$$\left\|\hat{g}(\|x\|)\right\| = \sum_{k=0}^{n} cA_k \, p_k(\|x\|) \, ,$$

et/ou de l'équation :

$$angle\left(\hat{g}(\|x\|)\right) = \sum_{k=0}^{n} c\varphi_k \, p_k(\|x\|) \, ,$$

avec $\{cA_0, cA_1, \cdots, cA_n\}$ coefficients de la caractéristique AM/AM, $\{c\varphi_0, c\varphi_1, \cdots, c\varphi_n\}$ coefficients de la caractéristique AM/PM, $\|g(\|x\|)\|$ module de l'approximation des non linéarités et $angle(g(\|x\|))$ phase de l'approximation des non linéarités,
- calcul de points d'interpolation d'abscisse $a_i$ et d'ordonnée $b_i$ de la caractéristique des non linéarités g pour la caractéristique AM/AM et/ou de points d'interpolation d'abscisse $c_i$ et d'ordonnée $d_i$ de la caractéristique des non linéarités g pour la caractéristique AM/PM.

3. Procédé selon la revendication 2, la base orthonormée étant obtenue par une orthonormalisation de Gram-Schmidt d'une base $\{1, x, x^2, x^3, \cdots, x^n\}$.

4. Procédé selon l'une des revendications 2 ou 3, le calcul des coefficients $\{cA_0, cA_1, \cdots, cA_n\}$ de la caractéristique AM/AM et/ou des coefficients $\{c\varphi_0, c\varphi_1, \cdots, c\varphi_n\}$ de la caractéristique AM/PM étant obtenu par projection de la séquence d'apprentissage sur la base orthonormée.

5. Procédé selon l'une des revendications 2 à 4, le calcul des points d'interpolation d'abscisse $a_i$ et d'ordonnée $b_i$ pour la caractéristique AM/AM étant réalisé selon l'équation :

$$b_i = \left\|\hat{g}(a_i)\right\| = \sum_{k=0}^{n} cA_k \, p_k(a_i) \, ,$$

et/ou le calcul des points d'interpolation d'abscisse c, et d'ordonnée $d_i$ pour la caractéristique AM/PM étant réalisé selon l'équation :

$$d_i = angle(\hat{g}(c_i)) = \sum_{k=0}^{n} c\varphi_k \, p_k(c_i)$$

6. Procédé selon la revendication 2, la base orthonormée étant obtenue par une orthonormalisation de Gram-Schmidt d'une base $\{1, x, x^*, x^2, xx^*, \cdots\}$ et le calcul de l'approximation des non linéarités étant effectué selon l'équation :

$$\hat{g}(\|x\|) = \left\|\hat{g}(\|x\|)\right\| \exp\left(j\,.angle\left(\hat{g}(\|x\|)\right)\right) = \left(\sum_{k=0}^{n} cA_k \, p_k(\|x\|)\right)\exp\left(j*\left(\sum_{k=0}^{n} c\varphi_k \, p_k(\|x\|)\right)\right)$$

7. Procédé selon l'une des revendications 1 à 6, la compensation des non linéarités (12) étant réalisée par :

- une étape de compensation de la caractéristique AM/AM à partir d'un polynôme d'interpolation obtenu à partir de points d'interpolation inverse d'abscisse $b_i$ et d'ordonnée $a_i$ calculés préalablement, et/ou

- une étape de compensation de la caractéristique AM/PM par soustraction d'une distorsion de phase évaluée à la phase du signal reçue.

**8.** Procédé selon la revendication 7, la compensation de la caractéristique AM/AM étant obtenue par le calcul du signal :

$$s_3'(t) = \sum_{j=1}^{m} a_j \prod_{i \neq j} \frac{\|s_2(t)\| - b_i}{b_j - b_i} \exp(j.angle(s_2(t))) \ ,$$

avec $s_2(t)$ le signal reçu, $\|s_2(t)\|$ le module du signal reçu, $angle(s_2(t))$ la phase du signal reçu, m le nombre de points d'interpolation, $(a_i,b_i)$ les coordonnées des points d'interpolation, le polynôme d'interpolation étant un polynôme de Lagrange, et/ou
la compensation de la caractéristique AM/PM étant obtenue par le calcul du signal :

$$s_3(t) = s_3'(t).\exp(-j * angle(\hat{g}(\|s_3\|))) \ ,$$

$s_3(t)$ étant le signal reçu compensé des non linéarité et g l'approximation des non linéarités.

**9.** Procédé selon l'une des revendications 1 à 6, la compensation des non linéarités (12) étant réalisée par une compensation conjointe des caractéristiques AM/AM et AM/PM à partir d'un polynôme d'interpolation complexe par le calcul du signal :

$$s_3(t) = \sum_{j=1}^{m} a_j \prod_{i \neq j} \frac{s_2(t) - b_i}{b_j - b_i}$$

avec $s_2(t)$ le signal reçu, $s_3(t)$ le signal reçu compensé des non linéarités, $a_i$ et $b_i$ étant respectivement les abscisses et les ordonnées de m points d'interpolation calculés préalablement.

**10.** Procédé selon l'une des revendications 1 à 9, comportant avant l'étape (10) d'estimation des non linéarités, une étape (8) d'estimation de la caractéristique du canal de transmission (4) à partir d'au moins une autre séquence d'apprentissage transmise à travers le canal de transmission (4).

**11.** Procédé selon la revendication 10, l'amplitude de l'autre séquence d'apprentissage étant choisie sensiblement constante.

**12.** Procédé selon l'une des revendications 10 ou 11, la caractéristique estimée du canal (4) étant prise en compte pour l'estimation des non linéarités.

**13.** Procédé selon l'une des revendications 10 à 12, comportant après l'étape (12) de compensation des non linéarités, une étape (14) d'égalisation compensant le bruit du canal (4) présent dans le signal reçu à partir de l'estimation (10) de la caractéristique du canal de transmission (4).

**14.** Procédé selon l'une des revendications précédentes, comportant après l'étape (12) de compensation des non linéarités, une étape (16) de démodulation et/ou de décodage.

**15.** Procédé selon l'une des revendications précédentes, les signaux et/ou séquences d'apprentissage reçus subissant un transformation de Fourier rapide (6).

**16.** Procédé selon l'une des revendications précédentes, la séquence d'apprentissage reçue au niveau du récepteur (100) pour l'estimation des non linéarités étant émise depuis l'émetteur (200) ou le récepteur (100).

**17.** Dispositif récepteur (100) destiné à recevoir des signaux émis par un émetteur (200) à travers un canal de transmission (4), comportant des moyens de compensation numérique de non linéarités comprenant :

- des moyens (106) d'estimation des non linéarités induites par l'émetteur et/ou le récepteur à partir d'au moins une séquence d'apprentissage reçue et déformée par lesdites non linéarités,
- des moyens (108) de compensation desdites non linéarités déformant un signal reçu à partir de l'estimation précédente des non linéarités.

**18.** Dispositif (100) selon la revendication 17, les moyens (106) d'estimation des non linéarités comportant :

- des moyens de calcul d'une base orthonormée de polynômes de projection $\{p_0, p_1, \cdots, p_n\}$,

- des moyens de calcul de l'approximation des non linéarités $\hat{g}(\|x\|)$ pour une caractéristique AM/AM et/ou une caractéristique AM/PM d'un élément de gain g sur lequel est ramené l'ensemble des non linéarités du système de communication, respectivement en fonction de l'équation :

$$\left\| \hat{g}(\|x\|) \right\| = \sum_{k=0}^{n} cA_k\, p_k\left(\|x\|\right) ,$$

et/ou de l'équation :

$$angle\left(\hat{g}(\|x\|)\right) = \sum_{k=0}^{n} c\varphi_k\, p_k\left(\|x\|\right) ,$$

avec $\{cA_0, cA_1, \cdots, cA_n\}$ coefficients de la caractéristique AM/AM, $\{c\varphi_0, c\varphi_1, \cdots, c\varphi_n\}$ coefficients de la caractéristique AM/PM, $\|g(\|x\|)\|$ module de l'approximation des non linéarités et $angle(g(\|x\|))$ phase de l'approximation des non linéarités,
- des moyens de calcul de points d'interpolation d'abscisse $a_i$ et d'ordonnée $b_i$ de la caractéristique des non linéarités g pour la caractéristique AM/AM et/ou de points d'interpolation d'abscisse $c_i$ et d'ordonnée $d_i$ de la caractéristique des non linéarités $g$ pour la caractéristique AM/PM.

**19.** Dispositif (100) selon la revendication 18, les moyens de calcul de la base orthonormée réalisant une orthonormalisation de Gram-Schmidt d'une base $\{1, x, x^2, x^3, \cdots, x^n\}$.

**20.** Dispositif (100) selon l'une des revendications 18 ou 19, les moyens de calcul des coefficients $\{cA_0, cA_1, \cdots, cA_n\}$ de la caractéristique AM/AM et/ou des coefficients $\{c\varphi_0, c\varphi_1, \cdots, c\varphi_n\}$ de la caractéristique AM/PM réalisant une projection de la séquence d'apprentissage sur la base orthonormée.

**21.** Dispositif (100) selon l'une des revendications 18 à 20, les moyens de calcul de points d'interpolation d'abscisse $a_i$ et d'ordonnée $b_i$ pour la caractéristique AM/AM résolvant l'équation :

$$b_i = \left\| \hat{g}(a_i) \right\| = \sum_{k=0}^{n} cA_k\, p_k(a_i) ,$$

et/ou les moyens de calcul des points d'interpolation d'abscisse $c_i$ et d'ordonnée $d_i$ pour la caractéristique AM/PM résolvant l'équation :

$$d_i = angle(\hat{g}(c_i)) = \sum_{k=0}^{n} c\varphi_k\, p_k(c_i)$$

**22.** Dispositif (100) selon la revendication 18, les moyens de calcul de la base orthonormée réalisant une orthonormalisation de Gram-Schmidt d'une base $\{1, x, x^*, x^2, xx^*, \cdots\}$ et les moyens de calcul de l'approximation des non linéarités résolvant l'équation :

$$g(\|\hat{x}\|) = \left\|g(\|\hat{x}\|)\right\| \exp\left(j.\,angle\left(g(\|\hat{x}\|)\right)\right) = \left(\sum_{k=0}^{n} cA_k\, p_k\left(\|x\|\right)\right) \exp\left(j*\left(\sum_{k=0}^{n} c\varphi_k\, p_k\left(\|x\|\right)\right)\right)$$

**23.** Dispositif (100) selon l'une des revendications 17 à 22, les moyens (108) de compensation des non linéarités comportant :

> - des moyens de compensation de la caractéristique AM/AM à partir d'un polynôme d'interpolation obtenu à partir de points d'interpolation d'abscisse $a_i$ et d'ordonnée $b_i$ calculés préalablement, et/ou
> - des moyens de compensation de la caractéristique AM/PM par soustraction d'une distorsion de phase évaluée à la phase du signal reçue.

**24.** Dispositif (100) selon la revendication 23, les moyens de compensation de la caractéristique AM/AM réalisant le calcul du signal

$$s_3'(t) = \sum_{j=1}^{m} a_j \prod_{i \neq j} \frac{\|s2(t)\| - b_i}{b_j - b_i} \exp(j.\,angle(s2(t)))$$

avec $s_2(t)$ le signal reçu, $\|s_2(t)\|$ le module du signal reçu, $angle(s_2(t))$ la phase du signal reçu, m le nombre de points d'interpolation, $(a_i, b_i)$ les coordonnées des points d'interpolation, et le polynôme d'interpolation étant un polynôme de Lagrange, et/ou
les moyens de compensation de la caractéristique AM/PM réalisant le calcul du signal :

$$s_3(t) = s_3'(t).\exp(-j*angle(g(\|\hat{s}_3\|)))\,,$$

$s_3(t)$ étant le signal reçu compensé des non linéarités et $\hat{g}$ l'approximation des non linéarités.

**25.** Dispositif (100) selon l'une des revendications 17 à 22, les moyens (108) de compensation des non linéarités réalisant une compensation conjointe des caractéristiques AM/AM et AM/PM à partir d'un polynôme d'interpolation complexe par le calcul du signal $s_3(t) = \sum_{j=1}^{m} a_j \prod_{i \neq j} \dfrac{s2(t) - b_i}{b_j - b_i}$ avec $s_2(t)$ le signal reçu, $s_3(t)$ le signal reçu compensé des non linéarités, $a_i$ et $b_i$ étant respectivement les abscisses et les ordonnées de m points d'interpolation calculés préalablement.

**26.** Dispositif (100) selon l'une des revendications 17 à 25, comportant des moyens (104) d'estimation de caractéristique de canal (4) de transmission à partir d'au moins une autre séquence d'apprentissage transmise à travers le canal de transmission (4).

**27.** Dispositif (100) selon la revendication 26, la caractéristique estimée du canal (4) étant prise en compte par les moyens (106) d'estimation des non linéarités.

**28.** Dispositif (100) selon l'une des revendications 26 ou 27, comportant des moyens (112) d'égalisation compensant le bruit du canal (4) présent dans le signal reçu à partir de l'estimation de la caractéristique du canal de transmission (4).

**29.** Dispositif (100) selon l'une des revendications 17 à 28, comportant des moyens (114) de démodulation et/ou de décodage.

**30.** Dispositif (100) selon l'une des revendications 17 à 29, comportant des moyens (102, 110) de transformation de Fourier rapide (FFT) réalisant une FFT aux signaux et/ou séquences d'apprentissage reçus.

**31.** Dispositif (100) selon l'une des revendications 17 à 30, ledit dispositif récepteur (100) étant une station de base sans fil.

**Patentansprüche**

**1.** Verfahren zur digitalen Kompensation von Nichtlinearitäten in einem Kommunikationssystem (300) mit einem Sender (200), einem Übertragungskanal (4) und einem Empfänger (100), umfassend:

   - zumindest einen Schritt (10) der Schätzung von Nichtlinearitäten, die durch den Sender und/oder den Empfänger induziert werden, und zwar ausgehend von zumindest einer Lernsequenz, die im Bereich des Empfängers (200) empfangen und von den Nichtlinearitäten verformt wird,
   - zumindest einen Schritt (12) der Kompensation der Nichtlinearitäten, die in im Bereich des Empfängers empfangenes Signal verformen, und zwar ausgehend von der vorhergehenden Schätzung der Nichtlinearitäten.

**2.** Verfahren nach Anspruch 1, wobei die Schätzung (10) der Nichtlinearitäten durch nachfolgende Schritte erfolgt:

   - Berechnen einer orthonormalisierten Basis von Projektions-Polynomen $\{p_0, p_1, \cdots, p_n\}$

   - Berechnung der Approximation der Nichtlinearitäten $g(\|\hat{x}\|)$ für eine Charakteristik AM/AM und/oder eine Charakteristik AM/PM eines Verstärkungselements g (2), auf das die gesamten Nichtlinearitäten des Kommunikationssystems (300) zurückzuführen sind, und zwar jeweils in Abhängigkeit von der Gleichung:

$$\|g(\|\hat{x}\|)\| = \sum_{k=0}^{n} cA_k \, p_k(\|x\|)$$

und/oder von der Gleichung:

$$angle\left(\hat{g}(\|x\|)\right) = \sum_{k=0}^{n} c\varphi_k \, p_k(\|x\|)$$

worin $\{cA_0, cA_1, \cdots, cA_n\}$ Koeffizienten der Charakteristik AM/AM sind, $\{c\varphi_0, c\varphi_1, \cdots, c\varphi_n\}$ Koeffizienten der Charakteristik AM/PM sind, $\|g(\|x\|)\|$ ein Modul der Approximation der Nichtlinearitäten und $angle(g(\|x\|))$ die Phase der Approximation der Nichtlinearitäten ist,
   - Berechnen der Interpolationspunkte mit der Abszisse $a_i$ und der Ordinate $b_i$ der Charakteristik der Nichtlinearitäten $\hat{g}$ für die Charakteristik AM/AM und/oder der Interpolationspunkte mit der Abszisse $c_i$ und der Ordinate $d_i$ der Charakteristik der Nichtlinearitäten $\hat{g}$ für die Charakteristik AM/PM.

**3.** Verfahren nach Anspruch 2, wobei die orthonormalisierte Basis durch eine Gram-Schmidtsches-Orthonormalisierung einer Basis $\{1, x, x^2, x^3, \cdots, x^n\}$ erhalten wird.

**4.** Verfahren nach einem der Ansprüche 2 oder 3, wobei die Berechnung der Koeffizienten $\{cA_0, cA_1, \cdots, cA_n\}$ der Charakteristik AM/AM und/oder der Koeffizienten $\{c\varphi_0, c\varphi_1, \cdots, c\varphi_n\}$ der Charakteristik AM/PM durch Projektion der Lernsequenz auf die orthonormalisierte Basis erhalten wird.

**5.** Verfahren nach einem der Ansprüche 2 bis 4, wobei die Berechnung der Interpolationspunkte mit der Abszisse $a_i$ und der Ordinate $b_i$ für die Charakteristik AM/AM nach folgender Gleichung erfolgt:

$$b_i = \|\hat{g}(a_i)\| = \sum_{k=0}^{n} cA_k \, p_k(a_i)$$

und/oder die Berechnung der Interpolationspunkte mit der Abszisse $c_i$ und der Ordinate $d_i$ für die Charakteristik

AM/PM nach folgender Gleichung erfolgt:

$$d_i = angle(\hat{g}(c_i)) = \sum_{k=0}^{n} c \varphi_k p_k(c_i)$$

6. Verfahren nach Anspruch 2, wobei die orthonormalisierte Basis durch eine Gram-Schmidtsches-Orthonormalisierung einer Basis $\{1, x, x^*, x^2, xx^*, \cdots\}$ erhalten wird und die Berechnung der Approximation der Nichtlinearitäten nach folgender Gleichung erfolgt:

$$\hat{g}(\|x\|) = \left|g(\|x\|)\right| \exp\left( j.angle\left( \hat{g}(\|x\|) \right) \right) = \left( \sum_{k=0}^{n} cA_k p_k(\|x\|) \right) \exp\left( j * \left( \sum_{k=0}^{n} c\varphi_k p_k(\|x\|) \right) \right)$$

7. Verfahren nach einem der Ansprüche 1 bis 6, wobei die Kompensation der Nichtlinearitäten (12) erfolgt durch:

- einen Schritt der Kompensation der Charakteristik AM/AM ausgehend von einem Interpolationspolynom, das ausgehend von umgekehrten Interpolationspunkten mit der Abszisse $b_i$ und der Ordinate $a_i$ erhalten wird, die zuvor berechnet wurden, und/oder
- einen Schritt der Kompensation der Charakteristik AM/PM durch Subtraktion einer Phasenverzerrung, die auf die empfangende Phase des Signals ausgewertet wurde.

8. Verfahren nach Anspruch 7, wobei die Kompensation der Charakteristik AM/AM durch folgende Berechnung des Signals erhalten wird:

$$s_3'(t) = \sum_{j=1}^{m} a_j \prod_{i \neq j} \frac{\|s_2(t)\| - b_i}{b_j - b_i} \exp(j.angle(s_2(t)))$$

wobei $s_2(t)$ das empfange Signal ist, $\|s_2(t)\|$ der Modul des empfangenen Signals ist, $angle(s_2(t))$ die Phase des empfangen Signals ist, m die Anzahl an Interpolationspunkten ist, $(a_i, b_i)$ die Koordinaten der Interpolationspunkte sind, wobei das Interpolationspolynom ein Lagrange-Polynom ist, und/oder die Kompensation der Charakteristik AM/PM durch folgende Berechnung des Signals erhalten wird:

$$s_3(t) = s_3'(t).\exp(-j * angle(\hat{g}(\|s_3'\|)))$$

wobei $s_3(t)$ das kompensierte, empfangene Signal der Nichtlinearitäten ist und $\hat{g}$ die Approximation der Nichtlinearitäten ist.

9. Verfahren nach einem der Ansprüche 1 bis 6, wobei die Kompensation der Nichtlinearitäten (12) durch eine gemeinsame Kompensation der Charakteristiken AM/AM und AM/PM ausgehend von einem komplexen Interpolationspolynom durch folgende Berechnung des Signals erfolgt:

$$s_3(t) = \sum_{j=1}^{m} a_j \prod_{i \neq j} \frac{s_2(t) - b_i}{b_j - b_i}$$

wobei $s_2(t)$ das empfangene Signal ist, $s_3(t)$ das gegenüber den Nichtlinearitäten kompensierte, empfangene Signal ist und $a_i$ und $b_i$ die Abszissen bzw. Ordinaten von m Interpolationspunkten sind, die zuvor berechnet wurden.

10. Verfahren nach einem der Ansprüche 1 bis 9, umfassend vor dem Schritt (10) der Schätzung der Nichtlinearitäten einen Schritt (8) der Schätzung der Charakteristik des Übertragungskanals (4) ausgehend von zumindest einer weiteren Lernsequenz, die durch den Übertragungskanal (4) übertragen wird.

11. Verfahren nach Anspruch 10, wobei die Amplitude der weiteren Lernsequenz im Wesentlichen konstant gewählt wird.

12. Verfahren nach einem der Ansprüche 10 oder 11, wobei die geschätzte Charakteristik des Kanals (4) bei der Schätzung der Nichtlinearitäten berücksichtigt wird.

13. Verfahren nach einem der Ansprüche 10 bis 12, umfassend nach dem Schritt (12) der Kompensation von Nichtlinearitäten einen Entzerrungsschritt (14), bei dem das Rauschen des Kanals (4) kompensiert wird, das in dem empfangenen Signal vorhanden ist, und zwar ausgehend von der Schätzung (10) der Charakteristik des Übertragungskanals (4).

14. Verfahren nach einem der vorangehenden Ansprüche, umfassend nach dem Schritt (12) der Kompensation der Nichtlinearitäten einen Schritt (16) der Demodulation und/oder Decodierung.

15. Verfahren nach einem der vorangehenden Ansprüche, wobei die empfangenen Signale und/oder Lernsequenzen einer schnellen Fourier-Transformation (6) unterliegen.

16. Verfahren nach einem der vorangehenden Ansprüche, wobei die im Bereich des Empfängers (100) für die Schätzung der Nichtlinearitäten empfangene Lernsequenz von dem Sender (200) oder dem Empfänger (100) ausgegeben wird.

17. Empfangsvorrichtung (100) zum Empfangen von Signalen, die von einem Sender (200) durch einen Übertragungskanal (4) ausgegeben werden, enthaltend Einrichtungen zur digitalen Kompensation von Nichtlinearitäten, enthaltend:

- Einrichtungen (106) zum Schätzen von Nichtlinearitäten, die durch den Sender und/oder den Empfänger induziert werden, und zwar ausgehend von zumindest einer Lernsequenz, die empfangen und von den Nichtlinearitäten verformt wird,
- Einrichtungen (108) zur Kompensation der Nichtlinearitäten, die ein empfangenes Signal verformen, und zwar ausgehend von der vorhergehenden Schätzung der Nichtlinearitäten.

18. Vorrichtung (100) nach Anspruch 17, wobei die Einrichtungen (106) zum Schätzen der Nichtlinearitäten enthalten:

- Einrichtungen zum Berechnen einer orthonormalisierten Basis von Projektions-Polynomen $\{p_0, p_1, \cdots, p_n\}$

- Einrichtungen zum Berechnen der Approximation der Nichtlinearitäten $g(\|\hat{x}\|)$ für eine Charakteristik AM/AM und/oder eine Charakteristik AM/PM eines Verstärkungselements g, auf das die gesamten Nichtlinearitäten des Kommunikationssystems zurückzuführen sind, und zwar jeweils in Abhängigkeit von der Gleichung:

$$\|g(\|\hat{x}\|)\| = \sum_{k=0}^{n} cA_k\, p_k(\|x\|)$$

und/oder von der Gleichung:

$$angle\big(g(\|\hat{x}\|)\big) = \sum_{k=0}^{n} c\varphi_k\, p_k(\|x\|)$$

worin $\{cA_0,\ cA_1,\ \cdots,\ cA_n\}$ Koeffizienten der Charakteristik AM/AM sind, $\{c\varphi_0,\ c\varphi_1,\ \cdots,\ c\varphi_n\}$ Koeffizienten der Charakteristik AM/PM sind, ein Modul der Approximation der Nichtlinearitäten und $angle(g(\|x\|))$ die Phase der Approximation der Nichtlinearitäten ist,
- Einrichtungen zum Berechnen der Interpolationspunkte mit der Abszisse $a_i$ und der Ordinate $b_i$ der Charak-

teristik der Nichtlinearitäten $\hat{g}$ für die Charakteristik AM/AM und/oder der Interpolationspunkte mit der Abszisse $c_i$ und der Ordinate $d_i$ der Charakteristik der Nichtlinearitäten $\hat{g}$ für die Charakteristik AM/PM.

**19.** Vorrichtung (100) nach Anspruch 18, wobei die Einrichtungen zum Berechnen der orthonormalisierten Basis eine Gram-Schmidtsches-Orthonormalisierung einer Basis $\{1, x, x^2, x^3, \cdots, x^n\}$ durchführen.

**20.** Vorrichtung (100) nach einem der Ansprüche 18 oder 19, wobei die Einrichtungen zur Berechnung der Koeffizienten $\{cA_0, cA_1, \cdots, cA_n\}$ der Charakteristik AM/AM und/oder der Koeffizienten $\{c\varphi_0, c\varphi_1, \cdots, c\varphi_n\}$ der Charakteristik AM/PM eine Projektion der Lernsequenz auf die orthonormalisierte Basis durchführen.

**21.** Vorrichtung (100) nach einem der Ansprüche 18 bis 20, wobei die Einrichtungen zur Berechnung der Interpolationspunkte mit der Abszisse $a_i$ und der Ordinate $b_i$ für die Charakteristik AM/AM folgende Gleichung lösen:

$$b_i = \left\| \hat{g}(a_i) \right\| = \sum_{k=0}^{n} cA_k \, p_k(a_i)$$

und/oder die Einrichtungen zur Berechnung der Interpolationspunkte mit der Abszisse $c_i$ und der Ordinate $d_i$ für die Charakteristik AM/PM folgende Gleichung lösen:

$$d_i = angle(\hat{g}(c_i)) = \sum_{k=0}^{n} c\varphi_k \, p_k(c_i)$$

**22.** Vorrichtung (100) nach Anspruch 18, wobei die Einrichtungen zum Berechnen der orthonormalisierten Basis durch eine Gram-Schmidtsches-Orthonormalisierung einer Basis $\{1, x, x^*, x^2, xx^*, \cdots\}$ durchführen und die Einrichtungen zur Berechnung der Approximation der Nichtlinearitäten folgende Gleichung lösen:

$$\hat{g}(\|x\|) = \left\| \hat{g}(\|x\|) \right\| \exp\left( j.angle\left[ \hat{g}(\|x\|) \right] \right) = \left( \sum_{k=0}^{n} cA_k \, p_k(\|x\|) \right) \exp\left( j * \left( \sum_{k=0}^{n} c\varphi_k \, p_k(\|x\|) \right) \right)$$

**23.** Vorrichtung (100) nach einem der Ansprüche 17 bis 22, wobei die Einrichtungen (100) zur Kompensation der Nichtlinearitäten enthalten:

- Einrichtungen zur Kompensation der Charakteristik AM/AM ausgehend von einem Interpolationspolynom, das ausgehend von umgekehrten Interpolationspunkten mit der Abszisse $a_i$ und der Ordinate $b_i$ erhalten wird, die zuvor berechnet wurden, und/oder
- Einrichtungen zur Kompensation der Charakteristik AM/PM durch Subtraktion einer Phasenverzerrung, die auf die empfangende Phase des Signals ausgewertet wurde.

**24.** Vorrichtung (100) nach Anspruch 23, wobei die Einrichtungen zur Kompensation der Charakteristik AM/AM folgende Berechnung des Signals durchführen:

$$s_3{}'(t) = \sum_{j=1}^{m} a_j \prod_{i \neq j} \frac{\|s_2(t)\| - b_i}{b_j - b_i} \exp(j.angle(s_2(t)))$$

wobei $s_2(t)$ das empfange Signal ist, $\|s_2(t)\|$ der Modul des empfangenen Signals ist, $angle(s_2(t))$ die Phase des empfangen Signals ist, m die Anzahl an Interpolationspunkten ist, $(a_i, b_i)$ die Koordinaten der Interpolationspunkte sind, wobei das Interpolationspolynom ein Lagrange-Polynom ist, und/oder die Einrichtungen zur Kompensation der Charakteristik AM/PM folgende Berechnung des Signals durchführen:

$$s_3(t) = s_3{}'(t).\exp\left(-j * angle\left(\hat{g}(\|s_3\|)\right)\right)$$

wobei $s_3(t)$ das gegenüber den Nichtlinearitäten kompensierte, empfangene Signal ist und $\hat{g}$ die Approximation der Nichtlinearitäten ist.

25. Vorrichtung (100) nach einem der Ansprüche 17 bis 22, wobei die Einrichtungen (108) zur Kompensation der Nichtlinearitäten eine gemeinsame Kompensation der Charakteristiken AM/AM und AM/PM ausgehend von einem komplexen Interpolationspolynom durch folgende Berechnung des Signals durchführen:

$$s_3(t) = \sum_{j=1}^{m} a_j \prod_{i \neq j} \frac{s_2(t) - b_i}{b_j - b_i}$$

wobei $s_2(t)$ das empfangene Signal ist, $s_3(t)$ das gegenüber den Nichtlinearitäten kompensierte, empfangene Signal ist und $a_i$ und $b_i$ die Abszissen bzw. Ordinaten von m Interpolationspunkten sind, die zuvor berechnet wurden.

26. Vorrichtung (100) nach einem der Ansprüche 17 bis 25, enthaltend Einrichtungen (104) zur Schätzung der Charakteristik des Übertragungskanals (4) ausgehend von zumindest einer weiteren Lernsequenz, die durch den Übertragungskanal (4) übertragen wird.

27. Vorrichtung (100) nach Anspruch 26, wobei die geschätzte Charakteristik des Kanals (4) von der Einrichtung (106) zur Schätzung der Nichtlinearitäten berücksichtigt wird.

28. Vorrichtung (100) nach einem der Ansprüche 26 oder 27, enthaltend Einrichtungen (112) zur Entzerrung, welche das Rauschen des Kanals (4) kompensieren, das in dem empfangenen Signal vorhanden ist, und zwar ausgehend von der Schätzung der Charakteristik des Übertragungskanals (4).

29. Vorrichtung (100) nach einem der Ansprüche 17 bis 28, enthaltend Einrichtungen (114) zur Demodulation und/oder Decodierung.

30. Vorrichtung (100) nach einem der Ansprüche 17 bis 29, enthaltend Einrichtungen (102, 110) zur schnellen Fourier-Transformation (FFT), die eine FFT bei den empfangenen Signalen und/oder Lernsequenzen durchführen.

31. Vorrichtung (100) nach einem der Ansprüche 17 bis 30, wobei die Empfangsvorrichtung (100) eine drahtlose Basisstation ist.

**Claims**

1. Method for the digital compensation of nonlinearities in a communication system (300) that includes a transmitter (200), a transmission channel (4) and a receiver (100), comprising:

   - at least one step (10) of estimating the nonlinearities induced by the transmitter and/or the receiver, from at least one learning sequence received at the receiver (200) end and distorted by said nonlinearities,
   - at least one step (12) of compensating said nonlinearities distorting a signal received at the receiver end from the previous estimation of nonlinearities.

2. Method according to claim 1, the nonlinearities being estimated (10) through steps of:

   - calculating an orthonormal base of projection polynomials $\{p_0, p_1, \cdots, p_n\}$,

   - calculating the nonlinearities approximation $\hat{g}(\|x\|)$ for an AM-AM characteristic and/or an AM-PM characteristic of a gain element g (2) to which all communication system (300) nonlinearities are reduced, as a function respectively of the equation:

$$\left\| g(\|\overset{\wedge}{x}\|) \right\| = \sum_{k=0}^{n} cA_k \, p_k \left( \|x\| \right) ,$$

and/or of the equation:

$$angle\left( \overset{\wedge}{g}(\|x\|) \right) = \sum_{k=0}^{n} c\varphi_k \, p_k \left( \|x\| \right) ,$$

with $\{cA_0, cA_1, \cdots, cA_n\}$ coefficients of the AM-AM characteristic, $\{c\varphi_0, c\varphi_1, \cdots, c\varphi_n\}$ coefficients of the AM-PM characteristic, $\|g(\|x\|)\|$ the nonlinearities approximation module and $angle(g(\|x\|))$ the nonlinearities approximation phase,
- calculating interpolation points, having abscissa $a_i$ and ordinate $b_i$, of the nonlinearities characteristic $\overset{\wedge}{g}$ for the AM-AM characteristic and/or interpolation points, having abscissa $c_i$ and ordinate $d_i$, of the nonlinearities characteristic $\overset{\wedge}{g}$ for the AM-PM characteristic.

3. Method according to claim 2, the orthonormal base being obtained by a Gram-Schmidt orthonormalisation of a base $\{1, x, x^2, x^3, \cdots, x^n\}$.

4. Method according to one of claims 2 or 3, the coefficients $\{cA_0, cA_1, \cdots, cA_n\}$ of the AM-AM characteristic and/or the coefficients $\{c\varphi_0, c\varphi_1, \cdots, c\varphi_n\}$ of the AM-PM characteristic being calculated by projection of the learning sequence on the orthonormal base.

5. Method according to one of claims 2 to 4, the interpolation points having abscissa $a_i$ and ordinate $b_i$ for the AM-AM characteristic being calculated according to the equation:

$$b_i = \left\| \overset{\wedge}{g}(a_i) \right\| = \sum_{k=0}^{n} cA_k \, p_k(a_i) ,$$

and/or the interpolation points having abscissa $c_i$ and ordinate $d_i$ for the AM-PM characteristic being calculated according to the equation:

$$d_i = angle(\overset{\wedge}{g}(c_i)) = \sum_{k=0}^{n} c\varphi_k \, p_k(c_i) .$$

6. Method according to claim 2, the orthonormal base being obtained by a Gram-Schmidt orthonormalisation of a base $\{1, x, x^* x^2, xx^*, \cdots\}$ and the nonlinearities approximation being calculated according to the equation:

$$g(\|\overset{\wedge}{x}\|) = \left\| \overset{\wedge}{g}(\|x\|) \right\| \exp\left( j.angle\left( \overset{\wedge}{g}(\|x\|) \right) \right) = \left( \sum_{k=0}^{n} cA_k \, p_k(\|x\|) \right) \exp\left( j*\left( \sum_{k=0}^{n} c\varphi_k \, p_k(\|x\|) \right) \right)$$

7. Method according to one of claims 1 to 6, the nonlinearities being compensated (12) by:

- a step of compensating the AM-AM characteristic from an interpolating polynomial obtained from inverse interpolation points having abscissa $b_i$ and ordinate $a_i$ calculated previously, and/or
- a step of compensating the AM-PM characteristic by subtracting a phase distortion evaluated at the received signal phase.

8. Method according to claim 7, the AM-AM characteristic being compensated by calculating the signal:

EP 1 887 749 B1

$$s_3{}'(t) = \sum_{j=1}^{m} a_j \prod_{i \neq j} \frac{\|s_2(t)\| - b_i}{b_j - b_i} \exp(j.angle(s_2(t))) \, ,$$

with $s_2(t)$ the signal received, $\|s_2(t)\|$ the received signal module, $angle(s_2(t))$ the received signal phase, m the number of interpolation points, $(a_i, b_i)$ the coordinates of the interpolation points, the interpolating polynomial being a Lagrange polynomial, and/or
the AM-PM characteristic being compensated by calculating the signal:

$$s_3(t) = s_3{}'(t).\exp(-j * angle(\hat{g}(\|s_3{}'\|))) \, ,$$

$s_3(t)$ being the nonlinearities compensated received signal and $\hat{g}$ the nonlinearities approximation.

9.  Method according to one of claims 1 to 6, the nonlinearities being compensated (12) by a joint compensation of the AM-AM and AM-PM characteristics from a complex interpolating polynomial by calculating the signal:

$$s_3(t) = \sum_{j=1}^{m} a_j \prod_{i \neq j} \frac{s_2(t) - b_i}{b_j - b_i} \, ,$$

with $s_2(t)$ the received signal, $s_3(t)$ the nonlinearities compensated received signal, $a_i$ and $b_i$ being respectively the abscissas and the ordinates of m interpolation points calculated previously.

10. Method according to one of claims 1 to 9, comprising before the nonlinearities estimation step (10), a step (8) of estimating the transmission channel (4) characteristic from at least one other learning sequence transmitted through the transmission channel (4).

11. Method according to claim 10, the amplitude of the other learning sequence being chosen substantially constant.

12. Method according to one of claims 10 or 11, the estimated channel (4) characteristic being taken into account for estimating the nonlinearities.

13. Method according to one of claims 10 to 12, comprising after the nonlinearities compensation step (12), an equalisation step (14) compensating for the channel (4) noise present in the signal received from the estimation (10) of the transmission channel (4) characteristic.

14. Method according to one of previous claims, comprising after the nonlinearities compensation step (12), a demodulation and/or decoding step (16).

15. Method according to one of previous claims, the signals and/or learning sequences received being subject to a fast Fourier transform (6).

16. Method according to one of previous claims, the learning sequence received at the receiver (100) end for estimating the nonlinearities being transmitted from the transmitter (200) or the receiver (100).

17. Receiver device (100) intended to receive signals transmitted by a transmitter (200) through a transmission channel (4), comprising digital nonlinearities compensation means that includes:

   - means (106) for estimating the nonlinearities induced by the transmitter and/or the receiver from at least one learning sequence received and distorted by said nonlinearities,
   - means (118) for compensating said nonlinearities distorting a signal received from the previous estimation of the nonlinearities.

18. Device (100) according to claim 17, the means (106) for estimating the nonlinearities comprising:

22

- means for calculating an orthonormal base of projection polynomials $\{p_0, p_1, \cdots, p_n\}$,
- means for calculating the nonlinearities approximation $g(\|\hat{x}\|)$ for an AM-AM characteristic and/or an AM-PM characteristic of a gain element g to which all communication system nonlinearities are reduced, as a function respectively of the equation:

$$\left\|g(\|\hat{x}\|)\right\| = \sum_{k=0}^{n} cA_k\, p_k\left(\|x\|\right) ,$$

and/or of the equation:

$$angle\left(\hat{g}(\|x\|)\right) = \sum_{k=0}^{n} c\varphi_k\, p_k\left(\|x\|\right) ,$$

with $\{cA_0, cA_n\}$ coefficients of the AM-AM characteristic, $\{c\varphi_0, c\varphi_1, \cdots, c\varphi_n\}$ coefficients of the AM-PM characteristic, $\|g(\|x\|)\|$ the nonlinearities approximation module and $angle(g(\|x\|))$ the nonlinearities approximation phase,
- means for calculating interpolation points, having abscissa $a_i$ and ordinate $b_i$, of the nonlinearities characteristic $g$ for the AM-AM characteristic and/or interpolation points, having abscissa $c_i$ and ordinate $d_t$, of the nonlinearities characteristic $g$ for the AM-PM characteristic.

19. Device (100) according to claim 18, the means for calculating the orthonormal base implementing a Gram-Schmidt orthonormalisation of a base $\{1, x, x^2, x^3, \cdots, x^m\}$.

20. Device (100) according to one of claims 18 or 19, the means for calculating the coefficients $\{cA_0, cA_1, \cdots, cA_n\}$ of the AM-AM characteristic and/or the coefficients $\{c\varphi_0, c\varphi_1, \cdots, c\varphi_n\}$ of the AM-PM characteristic implementing a projection of the learning sequence on the orthonormal base.

21. Device (100) according to one of claims 18 to 20, the means for calculating the interpolation points having abscissa $a_i$ and ordinate $b_i$ for the AM-AM characteristic resolving the equation:

$$b_i = \left\|\hat{g}(a_i)\right\| = \sum_{k=0}^{n} cA_k\, p_k(a_i) ,$$

and/or the means for calculating the interpolation points having the abscissa $c_i$ and ordinate $d_i$ for the AM-PM characteristic resolving the equation:

$$d_i = angle(\hat{g}(c_i)) = \sum_{k=0}^{n} c\varphi_k\, p_k(c_i) .$$

22. Device (100) according to claim 18, the means for calculating the orthonormal base implementing a Gram-Schmidt orthonormalisation of a base $\{1, x, x^*x^2, xx^*, \cdots\}$ and the means for calculating the nonlinearities approximation resolving the equation:

$$\hat{g}(\|x\|) = \|\hat{g}(\|x\|)\| \exp\left( j.angle\left( \hat{g}(\|x\|) \right) \right) = \left( \sum_{k=0}^{n} cA_k\, p_k\left(\|x\|\right) \right) \exp\left( j * \left( \sum_{k=0}^{n} c\varphi_k\, p_k\left(\|x\|\right) \right) \right)$$

23. Device (100) according to one of claims 17 to 22, the means (108) for compensating the nonlinearities comprising:

- means for compensating the AM-AM characteristic from an interpolating polynomial obtained from previously calculated interpolation points having abscissa $a_i$ and ordinate $b_i$, and/or
- means for compensating the AM-PM characteristic by subtracting a phase distortion evaluated at the received signal phase.

**24.** Device (100) according to claim 23, the means for compensating the AM-AM characteristic calculating the signal:

$$s_3{}'(t) = \sum_{j=1}^{m} a_j \prod_{i \neq j} \frac{\|s2(t)\| - b_i}{b_j - b_i} \exp(j.angle(s2(t)))$$

with $s_2(t)$ the received signal, $\|s_2(t)\|$ the received signal module, $angle(s_2(t))$ the received signal phase, m the number of interpolation points, $(a_i, b_i)$ the coordinates of the interpolation points, and the interpolating polynomial being a Lagrange polynomial, and/or
the means for compensating the AM-PM characteristic calculating the signal:

$$s_3(t) = s_3{}'(t).\exp(-j * angle(\hat{g}(\|s_3{}'\|))) ,$$

$s_3(t)$ being the nonlinearities compensated received signal and $\hat{g}$ the nonlinearities approximation.

**25.** Device (100) according to one of claims 17 to 22, the means (108) for compensating the nonlinearities implementing a joint compensation of the AM-AM and AM-PM characteristics from a complex interpolating polynomial by calculating the signal: $s_3(t) = \sum_{j=1}^{m} a_j \prod_{i \neq j} \frac{s2(t) - b_i}{b_j - b_i}$ with $s_2(t)$ the received signal, $s_3(t)$ the nonlinearities compensated received signal, $a_i$ and $b_i$ being the abscissas and ordinates respectively of m interpolation points calculated previously.

**26.** Device (100) according to one of claims 17 to 25, comprising means (104) for estimating a transmission channel (4) characteristic from at least one other learning sequence transmitted through the transmission channel (4).

**27.** Device (100) according to claim 26, the estimated channel (4) characteristic being taken into account by the means (106) for estimating the nonlinearities.

**28.** Device (100) according to one of claims 26 or 27, comprising equalization means (112) compensating the channel (4) noise present in the received signal from the estimation of the transmission channel (4) characteristic.

**29.** Device (100) according to one of claims 17 to 28, comprising means (114) for demodulating and/or decoding.

**30.** Device (100) according to one of claims 17 to 29, comprising fast Fourier transform (FFT) means (102, 110) implementing an FFT on the received signals and/or learning sequences.

**31.** Device (100) according to one of claims 17 to 30, said receiver device (100) being a wireless base station.

FIG. 1

FIG. 2

FIG. 3

FIG. 4A

FIG. 4B

FIG. 5

FIG. 6

**EP 1 887 749 B1**

## RÉFÉRENCES CITÉES DANS LA DESCRIPTION

**Documents brevets cités dans la description**

- US 6304140 B

- WO 2006019612 A